# EUROPÄISCHE PATENTSCHRIFT

(11) **EP 2 259 350 B1**
(45) Veröffentlichungstag und Bekanntmachung des Hinweises auf die Patenterteilung: **07.06.2017**
(21) Anmeldenummer: 10179592.0
(22) Anmeldetag: 15.10.1998
(51) Int. Cl.: H01L 33/48, H01L 31/0203, H01L 33/64, H01L 31/024

(54) **Verfahren zur Herstellung eines optoelektronischen Bauelementes**
Method of making an optoelectronic component
Méthode de fabrication d'un composant opto-électronique

(30) Priorität: 23.10.1997 DE 19746893
(43) Veröffentlichungstag der Anmeldung: 08.12.2010
(62) Teilanmeldung aus: 98119536.5
(73) Patentinhaber: OSRAM Opto Semiconductors GmbH, 93055 Regensburg (DE)
(72) Erfinder: Hurt, Hans, 93087 Alteglofsheim (DE); Brunner, Herbert, 93161 Sinzing (DE)
(74) Vertreter: Epping - Hermann - Fischer

(56) Entgegenhaltungen:
- EP-A- 0 062 300
- EP-A- 0 493 051
- JP-A- H07 202 271
- US-A- 5 525 205

## Beschreibung

Die Erfindung bezieht sich auf die Herstellung eines optoelektronischen Bauelements mit einem strahlungsempfangenden oder strahlungsemittierenden Halbleiterchip, der an bzw. auf einem Sockelteil befestigt und mit wenigstens zwei für die elektrische Kontaktgabe des Bauelementes dienenden Elektrodenanschlüssen aus einem elektrisch leitenden Anschluss-Material verbunden ist.

Derartige optoelektronische Halbleiterbauelemente werden in Massenstückzahlen hergestellt und dienen als Wandler optischer Signale oder Energie in elektrische Signale oder Energie bzw. umgekehrt. Strahlungsempfänger bzw. strahlungsempfindliche Bauelemente sind beispielsweise Photodioden oder Phototransistoren. Zu den Sendern bzw. Strahlung aussendenden Bauelementen gehören (sichtbares) Licht emittierende Dioden (LED) und Infrarotstrahlung emittierende Dioden (IRED). Diese optoelektronischen Bauelemente werden zweckmäßig im Waferverband hergestellt und nach Fertigstellung in Form von quaderförmigen Chips aus dem Waferverband vereinzelt. Die fertigen Halbleiterchips werden dann je nach Verwendungszweck auf einem geeigneten Träger befestigt, kontaktiert und in eine Umhüllung aus transparentem Kunststoff eingebettet. Neben einem Schutz für den Halbleiterchip sowie den Kontaktdrähten kommt der Kunststoffumhüllung daneben auch die Funktion einer in bzw. auf dem Chip verbesserten Strahlungseinkopplung bzw. Strahlungsauskopplung zu.

Neben den allseits bekannten radialen Bauformen mit einem Plastikgehäuse und nach einer Seite herausragenden, länglichen Elektrodenanschlüssen sind insbesondere auch für die Oberflächenmontage geeignete Bauformen von Leuchtdioden bekannt, bei denen ein sogenanntes Leadframe als vorgefertigtes Trägerteil für den Halbleiterchip vorgesehen ist, und die Elektrodenanschlüsse als aus dem Plastikgehäuse seitlich herausgeführten und abgebogenen Beinchen ausgebildet ist. Bei der Herstellung solcher LEDs für die Oberflächenmontage wird ein endlos gestanztes Leiterband mit einem hochtemperaturfesten Thermoplast umspritzt. Bei einer weiteren Verfahrenstechnik wird die Leuchtdiode erst nach der Vergussfertigung in einen für die Oberflächenmontage geeigneten Halter eingebaut. Aus der DE 31 28 187 A1 ist ein optoelektronisches Bauelement bekannt, bei dem zwei auf einem Träger flächig aufgebrachte, mit dem Halbleiterkörper verbundene Anschlüsse vorgesehen sind, die sich von der den Halbleiterkörper tragenden Außenfläche des Trägers bis auf wenigstens eine weitere Außenfläche des Trägers erstrecken und dort eine Anschlusskontaktfläche bilden.

Aus der DE 196 21 124 A1 ist ein optoelektronischer Wandler mit einem auf einer Trägereinheit befestigten Halbleiterchip bekannt. Die Trägereinheit besitzt einen Chipmontagebereich, dem eine Anzahl von Anschlussteilen zugeordnet ist. Diese Anschlussteile sind mit elektrischen Anschlussflächen versehen, die eine Ebene definieren, deren Abstand zum Chipmontagebereich größer ist als die maximale Höhe des Halbleiterchips gegebenenfalls einschließlich sämtlicher Anschlussleiter und/oder Abdeckmittel bezogen auf den Chipmontagebereich.

Aus der Jap. J. Appl. Physics, Bd. 27, 1988, S. L1764 - L1767 ist ein Verfahren bekannt, bei dem ein isolierendes Substrat mit einer dünnen Beschichtung aus Kupfer durch Abscheidung aus einer Flüssigkeit chemisch und ohne Einwirkung eines äußeren Stromflusses überzogen wird ("electroless plating"). Sodann wird die Kupfer-Beschichtung selektiv geätzt mit Hilfe der Photolithographie, wobei eine Maskenschicht abgeschieden und strukturiert wird, wodurch von dem Maskenmaterial abgedeckte und nicht abgedeckte Bereiche der Beschichtung ausgewiesen werden, und selektiv die nicht durch das Material der Maskenschicht abgedeckten Bereiche durch Ätzen entfernt werden.

In der Druckschrift EP 0 493 051 A1 ist ein Bauelement mit einer Ausnehmung für einen Licht emittierenden Chip und einer Ausnehmung für einen Licht empfangenden Chip beschrieben, bei dem in den Ausnehmungen eine metallische abgeschiedene Verdrahtung ausgebildet ist Es wird vorgeschlagen das Anschluss-Material durch chemische Abscheidung aus einer Flüssigkeit ohne Einwirkung eines äußeren elektrischen Stromflusses abzuscheiden und dann die abgeschiedene Schicht durch Ätzen zu strukturieren. Die Druckschrift EP 0 062 300 A2 betrifft ein Verfahren zur Herstellung von Leiterplatten.

Aus der Druckschrift JP 07-202271 A ist ein Bauelement bekannt, bei dem ein Licht emittierender Diodenchip in einer Ausnehmung einer Platte angeordnet ist und der Chip über eine Drahtverbindung mit einem Muster auf der Oberfläche der Platte verbunden ist.

In der Druckschrift US 5,525,205 A wird ein Verfahren zur Ausbildung einer Schaltung durch Laser angegeben.

Der Erfindung liegt die Aufgabe zugrunde, ein Verfahren zur Herstellung eines optoelektronisches Bauelements, insbesondere SMT-Optobauelements (SMT = Surface Mounted Technologie) anzugeben, welches bei weiterhin verringerter Baugröße des Bauelementes insbesondere bei hohen Stückzahlen auch bei unterschiedlichen Bauformen eine kostengünstige Herstellung ermöglicht.

Diese Aufgabe wird durch ein Verfahren zur Herstellung eines optoelektronischen Bauelementes nach Anspruch 1 gelöst.

Das durch das erfindungsgemäße Verfahren hergestellte Bauelement zeichnet sich dadurch aus, dass die Elektrodenanschlüsse durch eine auf den äußeren Oberflächen des Sockelteils abgeschiedene dünne Beschichtung ausgebildet sind.

Das erfindungsgemäße Verfahren zeichnet sich dadurch aus, dass das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird, auf der dünnen Sockelteil-Beschichtung eine Maskenschicht abgeschieden wird, die Maskenschicht strukturiert wird, wodurch von dem Maskenmaterial abgedeckte und nicht abgedeckte Bereiche der Sockelteil-Beschichtung ausgewiesen werden, und selektiv die nicht durch das Material der Maskenschicht abgedeckten Bereiche durch Ätzen entfernt werden und die Strukturierung der Maskenschicht unter der Einwirkung eines Teilchen- oder Lichtstrahls erfolgt. Ein alternatives, vorliegend nicht beanspruchtes Verfahren zur Herstellung eines optoelektronischen Bauelementes zeichnet sich bei dadurch aus, dass das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird, die dünne Beschichtung des Sockelteils strukturiert wird und hierbei einzelne, elektrisch voneinander isolierte Bereiche der Beschichtung gefertigt werden, selektiv auf einigen vorbestimmten der sonach gefertigten Bereichen der dünnen Beschichtung eine weitere dünne Schicht aus einem Hilfsmaterial durch galvanische Abscheidung unter der Wirkung eines äußeren elektrischen Stromflusses abgeschieden wird, wodurch die Schichtdicke dieser vorbestimmten Bereiche der Beschichtung verstärkt wird, und die nicht verstärkten Bereiche der Sockelteil-Beschichtung selektiv durch Ätzen entfernt werden.

Die mit der Erfindung erzielten Vorteile bestehen insbesondere darin, dass durch die Verwendung eines vorgefertigten Kunststoff-Sockelteils, vorzugsweise Kunststoff-Spritzteils, auf dem die für die elektrische Kontaktgabe das Bauelementes dienenden Elektrodenanschlüsse in einer strukturierten Beschichtungstechnik aufgebracht werden, Optobauelemente für die Oberflächenmontagetechnik (SMT) mit geringeren Bauhöhen mit wesentlich geringen Fertigungskosten hergestellt werden können. Aufgrund einer flexiblen Prozessführung ermöglicht die Erfindung die Herstellung unterschiedlichster Bauformen und Elektrodenanschlussformen; auf ebenso kostengünstige und einfache Weise sind mehrere Bauelemente im Verbund, sogenannte Arrays herstellbar. Eine breite Palette von Bauelementmodifikationen kann mit nur einem Sockelteil abgedeckt werden. Dieses Sockelteil ist beispielsweise bei einer LED als Bauelement in seiner Gestaltung wesentlich einfacher als die herkömmlichen LED-Träger mit Leadframe bzw. mit geprägtem Reflektor.

Weitere Zweckmäßigkeiten der Erfindung ergeben sich aus den Unteransprüchen.

Das Bauelement beziehungsweise das Verfahren können sich insbesondere durch mindestens einen der folgenden Aspekte auszeichnen, welche zur vereinfachten Darstellung nummeriert und mit Rückbezügen versehen sind. Die beanspruchte Erfindung ist in den Ansprüchen definiert, während die folgenden Aspekte auch nicht beanspruchte Bauelemente und Verfahren auflisten.
1. Optoelektronisches Bauelement mit einem strahlungsempfangenden oder strahlungsemittierenden Halbleiterchip, der an bzw. auf einem Sockelteil befestigt und mit wenigstens zwei für die elektrische Kontaktgabe des Bauelementes dienenden, auf den äußeren Oberflächen des Sockelteils ausgebildete Elektrodenanschlüssen aus einem elektrisch leitenden Anschluss-Material verbunden ist, wobei die Elektrodenanschlüsse durch eine auf den äußeren Oberflächen des Sockelteils abgeschiedene strukturierte, dünne Beschichtung ausgebildet sind.
2. Bauelement nach Aspekt 1, wobei sich die Elektrodenanschlüsse ausgehend von der dem Halbleiterchip zugewandeten Oberseite des Sockelteils über randseitige Abschnitte des Sockelteils bis zur Unterseite des Sockelteils erstrecken.
3. Bauelement nach Aspekt 1 oder 2, wobei der Halbleiterchip mit seiner Unterseite auf einem Elektrodenanschluss aufsitzt.
4. Bauelement nach einem der vorhergehenden Aspekte 1 bis 3, wobei das Sockelteil eine Wärmesenke aus thermisch leitenden Material aufweist, welches sich in thermischen Kontakt mit dem Halbleiterchip befindet.
5. Verfahren zur Herstellung eines optoelektronischen Bauelementes mit einem strahlungsempfangenden oder strahlungsemittierenden Halbleiterchip, der an bzw. auf einem Sockelteil befestigt und mit wenigstens zwei für die elektrische Kontaktgabe des Bauelementes dienenden Elektrodenanschlüssen aus einem elektrisch leitenden Anschluss-Material verbunden ist,
   dadurch **gekennzeichnet**, dass
   die Elektrodenanschlüsse durch eine auf den äußeren Oberflächen des Sockelteils abgeschiedene strukturierte, dünne Beschichtung ausgebildet werden.
6. Verfahren nach Aspekt 5,
   dadurch **gekennzeichnet**, dass
   - das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird,
   - die dünne Beschichtung des Sockelteils strukturiert wird und hierbei einzelne, elektrisch voneinander isolierte Bereiche der Beschichtung gefertigt werden,
   - selektiv auf einigen vorbestimmten der sonach gefertigten Bereichen der dünnen Beschichtung eine weitere dünne Schicht aus einem Hilfsmaterial durch galvanische Abscheidung unter der Wirkung eines äußeren elektrischen Stromflusses abgeschieden wird, wodurch die Schichtdicke dieser vorbestimmten Bereiche der Beschichtung verstärkt wird, und
   - die nicht verstärkten Bereiche der Sockelteil-Beschichtung selektiv durch Ätzen entfernt werden.
7. Verfahren zur Herstellung eines optoelektronischen Bauelementes mit einem strahlungsempfangenden oder strahlungsemittierenden Halbleiterchip, der an bzw. auf einem Sockelteil befestigt und mit wenigstens zwei für die elektrische Kontaktgabe des Bauelementes dienenden Elektrodenanschlüssen aus einem elektrisch leitenden Anschluss-Material verbunden ist,
   dadurch **gekennzeichnet**, dass
   - das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird,
   - auf der dünnen Sockelteil-Beschichtung eine Maskenschicht abgeschieden wird,
   - die Maskenschicht strukturiert wird, wodurch von dem Maskenmaterial abgedeckte und nicht abgedeckte Bereiche der Sockelteil-Beschichtung ausgewiesen werden, und
   - selektiv die nicht durch das Material der Maskenschicht abgedeckten Bereiche durch Ätzen entfernt werden.
8. Verfahren nach Aspekt 5, 6 oder 7,
   dadurch **gekennzeichnet**,
   dass die Strukturierung der Sockelteil-Beschichtung bzw. der Maskenschicht unter der Einwirkung eines Teilchen- oder Lichtstrahls, insbesondere Laserstrahls erfolgt.
9. Verfahren nach einem der Aspekte 5 bis 8,
   dadurch **gekennzeichnet**,
   dass das selektive Entfernen der nicht verstärkten bzw. nicht abgedeckten Bereiche der Sockelteil-Beschichtung durch chemisches Nassätzen erfolgt.
10. Verfahren nach einem der Aspekte 5 bis 9,
   dadurch **gekennzeichnet**,
   dass die Beschichtung des Sockelteils mit dem elektrisch leitenden Anschluss-Material allseitig erfolgt.
11. Verfahren nach einem der Aspekte 5 bis 10,
   dadurch **gekennzeichnet**,
   dass das Anschluss-Material der Sockel-Beschichtung Kupfer aufweist.
12. Verfahren nach einem der Aspekte 5 bis 11,
   dadurch **gekennzeichnet**,
   dass das Sockelteil aus Kunststoff besteht und im Spritzgussverfahren vorgefertigt wird.
13. Verfahren nach einem der Aspekte 6 bis 12,
   dadurch **gekennzeichnet**,
   dass das Material der Maskenschicht Zinn aufweist. Anhand der Zeichnung werden bevorzugte Ausführungsbeispiele der Erfindung weiter erläutert. Es zeigen:
   - Figur 1: eine schematische Schnittansicht eines fertiggestellten optoelektronischen Bauelementes in der Form einer lichtemittierenden Diode mit Linse für die Oberflächenmontage;
   - Figur 2: eine schematische Draufsicht der im Plattenverbund gefertigten LEDs;
   - Figuren 3A bis 3C: in schematischen Ansichten die aufeinander folgenden Prozess-Schritte zur Fertigung des Sockelteils nach einem Beispiel eines vorliegend nicht beanspruchten Verfahrens; und
   - Figuren 4A bis 4C: in schematischen Ansichten die aufeinander folgenden Prozess-Schritte zur Fertigung des Sockelteils nach einem Ausführungsbeispiel der Erfindung.

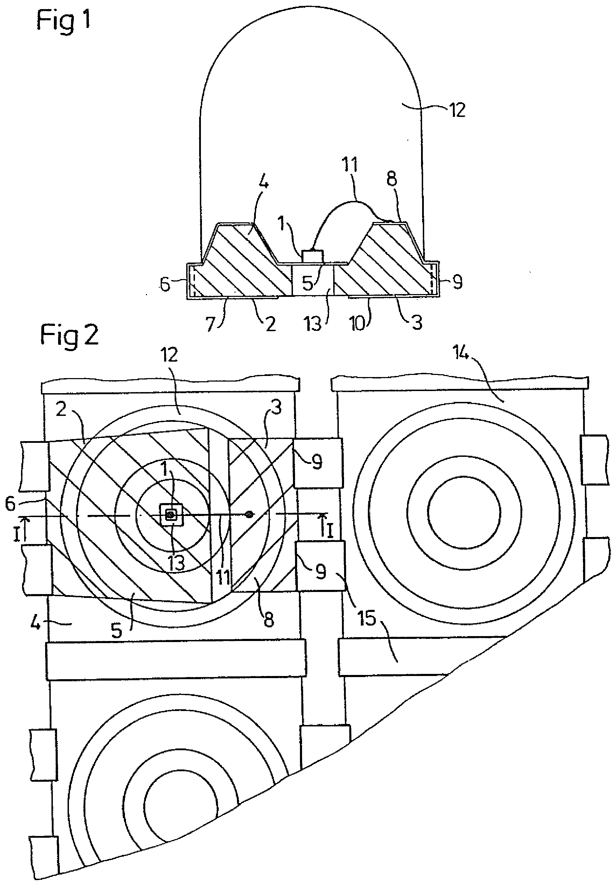

In Figur 1 ist als Beispiel eines durch das erfindungsgemäße Verfahren hergestellten optoelektronischen Bauelements eine Lumineszenz- bzw. Leuchtdiode (LED) dargestellt. Die LED besitzt einen Halbleiterchip 1 als strahlungsemittierendes Element. Ein Sockelteil 4 als Chipträger ist auf vorbestimmten Abschnitten seiner äußeren Oberflächen mit zwei Elektrodenanschlüssen 2, 3 aus einem elektrisch leitenden Anschluss-Material, welches insbesondere Kupfer aufweist, beschichtet. Hierbei erstreckt sich die elektrisch leitende Fläche des einen Elektrodenanschlusses 2 ausgehend von einem Abschnitt 5 auf der dem Halbleiterchip 1 zugewandten Oberseite des Sockelteils 4 über randseitige Abschnitte 6 hinweg bis zu Abschnitten 7 auf der Unterseite des Sockelteils 4. Entsprechend erstreckt sich die Fläche des zweiten Elektrodenanschlusses 3 auf der anderen Seite des Sockelteils 4 ausgehend von einem Abschnitt 8 über randseitige Abschnitte 9 bis zu Abschnitten 10 auf der Unterseite des Sockelteils 4. Der Halbleiterchip 1 ist auf dem Abschnitt 5 des Elektrodenanschlusses 2 zweckmäßig mittels eines geeigneten Leitklebers befestigt. Die Kontaktierung des Chips 1 mit dem zweiten Elektrodenanschluss 3 erfolgt über einen Bonddraht 11. Ein Linsenteil 12 aus transparentem Kunststoff ist auf dem Sockelteil 4 geformt. Der Sockelteil 4 kann eine eingearbeitete Wärmesenke 13 aus Kupfer aufweisen.

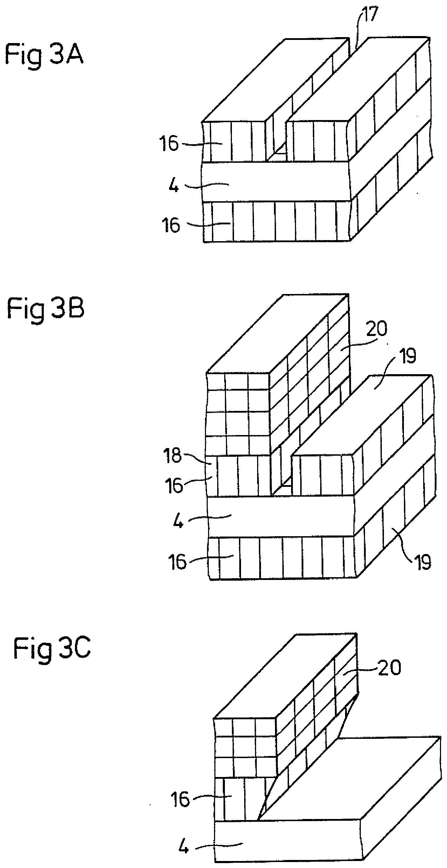

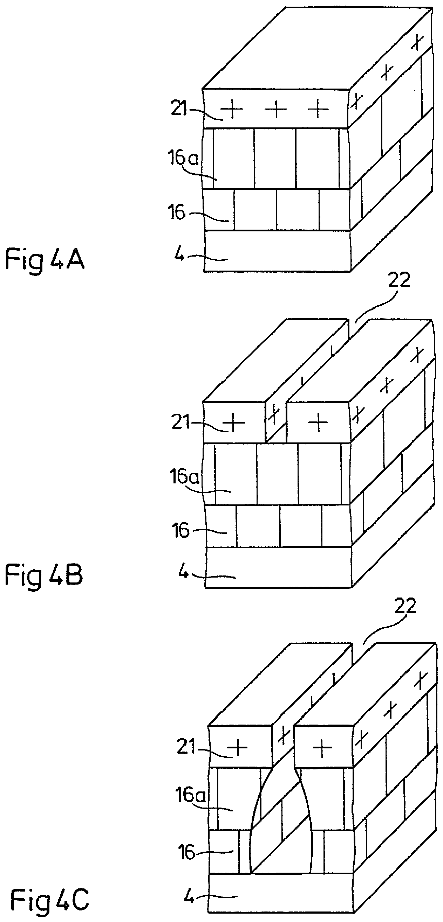

Zweckmäßigerweise werden in einem Arbeitsgang gleichzeitig mehrere optoelektronische Bauelemente bzw. Sockelteile mit den Elektrodenanschlüssen gefertigt. Figur 2 zeigt einen zu diesem Zweck im Spritzgussverfahren vorgefertigten, plattenförmigen Trägerkörper 14 aus einem geeigneten Hochtemperatur-Thermoplastmaterial, der mit Durchbrüchen 15 zwischen den später zu einzelnen Sockelteilen 4 versehen ist, an denen einerseits ein Transportwerkzeug zur Beförderung des Trägers 14, und andererseits ein Trennwerkzeug zum Vereinzeln der Bauelemente angreifen kann. In dem plattenförmigen Trägerkörper 14 der Sockelteile werden zunächst die Elektrodenanschlüsse 2, 3 gefertigt, die als Leiterbahnen für die Chipmontage und für die elektrische Kontaktgabe des Bauelementes für eine Oberflächenmontage (SMT) dienen. Die Fertigung der Elektrodenanschlüsse erfolgt anhand dem in den Figuren 4A bis 4C erläuterten Ausführungsbeispiel. Alternativ können die Elektrodenanschlüsse gemäß dem anhand der Figuren 3A bis 3C erläuterten nicht erfindungsgemäßen Beispiel gefertigt werden.

Nach der Fertigstellung des Sockelteils 4 mit Elektrodenanschlüssen 2, 3 wird - noch im Verbund des Körpers 14 - der Halbleiterchip 1 gebondet und der Anschlussdraht 11 kontaktiert. Bei Bedarf kann das Sockelteil so beschaffen sein, dass auch mehrere Halbleiterchips pro Bauteil montiert werden können, wobei in diesem Fall in der Regel mehr als zwei Elektrodenanschlüsse benötigt werden. Daran anschließend wird die Linse 12 aufgebracht. Dies kann unter Einsatz einer geeignet ausgebildeten Formenplatte durchgeführt werden, deren Formen die Linsenkörper bilden, und welche zum Chipträgerverband ausgerichtet werden kann. Die einzelnen Formen werden beispielsweise mit Epoxidharz gefüllt, und das Chipträgersubstrat mit dem Gesicht nach unten auf die Formenplatte zentriert. Nach dem Anhärten des Epoxidharzes für die Linsen wird das Substrat entformt, wobei die Epoxidharzlinsen bei Bedarf noch nachgehärtet werden können. Daran anschließend wird der mit den Linsen versehene Chipträgerkörper 14 vermittels eines Sägeprozesses in Einzelbauteile oder auch Arrays vereinzelt. Für eine optimale Beschaltung können die "Leiterbahnen" der Elektrodenanschlüsse 2, 3 ebenfalls mittels Sägen durchgetrennt werden. Anschließend können die vereinzelten Bauelemente bzw. Arrays unter dem Einsatz eines Automaten getestet und verpackt werden. Die Verpackung kann entweder in sogenannten Tapes oder auch in Tubes, insbesondere im Falle von Arrays, erfolgen. Darüber hinaus können weitere Verpackungen zum Einsatz gelangen, beispielsweise vermittels einer Bauteilträgerfolie oder dergleichen.

Obzwar der Chipträgerkörper 14 bei der besonders bevorzugten Ausführungsform aus einem Kunststoff-Material besteht, kann im Prinzip auch eine Metallplatte Verwendung finden, die zur elektrischen Isolierung entweder mit Einsätzen versehen ist oder vermittels einer Kunststoff-Folie beschichtet ist. Hierbei kann der Trägerkörper 14 im Sinne einer weiteren Reduktion der Fertigungskosten auch als wiederverwendbares Bauteil ausgebildet sein.

Weiterhin kann die Formenplatte zur Fertigung der Linsen so gestaltet sein, dass die einzelnen Linsenformen miteinander verbunden sind, und beim Gießen der Linsen ein Niveauabgleich des Gussmittels stattfinden kann, um eine genaue Vergusshöhe zu gewährleisten. Zusätzlich können Überlaufreservoires angebracht sein. Zwischen den Formen für die Linsen können darüber hinaus Bohrungen für Auswerferstifte vorhanden sein, um die Entformung zu ermöglichen bzw. zu vereinfachen. Um den Entformungsstress zu minimieren und die Genauigkeit zu maximieren sollten die Ausdehnungskoeffizienten von Chipträgerkörper 14 und Formenplatte möglichst gut angepasst sein, zweckmäßig ist hierbei die Verwendung eines Trägerkörpers aus LCP-Material (flüssigkristallines Polymer) und einer Formenplatte aus Metall.

Die Figuren 3A bis 3C zeigen schematisch die aufeinander folgenden Prozess-Schritte zur Fertigung der in Verbund befindlichen Sockelteile 4 mit den Elektrodenanschlüssen gemäß einem Beispiel eines vorliegend nicht beanspruchten Verfahrens. Nach der Figur 3A wird das Sockelteil 4 in einem ersten Schritt allseitig mit einer dünnen Beschichtung 16 aus dem elektrisch leitenden Anschluss-Material, insbesondere Kupfer, durch Abscheidung aus einer Flüssigkeit überzogen. Diese Abscheidung erfolgt chemisch, d.h. ohne Einwirkung eines äußeren elektrischen Stromflusses. Daran anschließend erfolgt die Strukturierung der Sockelteil-Beschichtung 16 unter der Einwirkung eines Teilchen- oder Lichtstrahls, insbesondere Laserstrahls. An den Stellen, wo der Laserstrahl geführt wird, entstehen durch Abdampfung des Anschluss-Materials bis zum Material des Sockelteils 4 reichende Strukturierungsgräben 17, die jeweils benachbarte Bereiche des Anschluss-Materials 16 elektrisch voneinander isolieren. In einem darauf folgenden Arbeitsschritt wird gemäß Figur 3B selektiv auf einigen vorbestimmten der solchermaßen gefertigten Bereichen 18 eine weitere dünne Schicht 20 aus einem Hilfsmaterial, insbesondere wiederum Kupfer aufweisend, durch galvanische Abscheidung aufgebracht, d.h. unter der Wirkung eines äußeren elektrischen Stromflusses durch den betroffenen Bereich 18. Auf diese Weise wird die Schichtdicke dieses Bereiches 18 um den Wert der Schichtdicke des Materials 20 verstärkt, während die nicht mit einem elektrischen Strom beaufschlagten Bereiche 19 unverändert bleiben. Daran anschließend können nach Figur 3C die nicht verstärkten Bereiche 19 der Sockelteil-Beschichtung vollständig durch nass-chemisches Ätzen entfernt werden, wobei nach dem Ätzen die Schichtdicke des Bereiches 20 etwas verringert wird.

Die Figuren 4A bis 4C zeigen in aufeinander folgenden Arbeitsschritten ein Ausführungsbeispiel zur Fertigung der Sockelteile 4 mit Elektrodenanschlüssen 2, 3. Wiederum wird in einem ersten Schritt allseitig eine dünne Beschichtung 16 aus dem elektrisch leitenden Anschluss-Material auf chemischem Wege, d.h. ohne Einwirkung eines äußeren elektrischen Stromflusses aufgebracht, wobei in den Figuren 4A bis 4C aus Gründen der übersichtlicheren Darstellung die Beschichtung lediglich auf der Oberseite des Sockelteils 4 gezeigt ist, und eine nähere Darstellung der Unterseite weggelassen ist. Die Stärke der Beschichtung 16 kann durch (chemisches oder auch galvanisches) Aufbringen von weiterem Material 16a verstärkt werden. Es folgt eine vorzugsweise chemische Beschichtung mit einer dünnen Maskenschicht 21, beispielsweise aus Zinn-Material. Die Maskenschicht 21 wird nach Figur 4B strukturiert, und zwar unter der Einwirkung eines Teilchen- oder Lichtstrahls, insbesondere Laserstrahls. Nach Figur 4C wird die Struktur der Maske 21 nass-chemisch auf die Beschichtung 16, 16a übertragen, d.h. es werden selektiv die nicht durch das Material der Maskenschicht 21 abgedeckten Bereiche durch Ätzen entfernt. Auf diese Weise kann mit vergleichsweise geringen Fertigungskosten die gewünschte Struktur der flächenhaften Elektrodenanschlüsse 2 und 3 hergestellt werden.

## Patentansprüche

1. Verfahren zur Herstellung eines optoelektronischen Bauelementes mit einem strahlungsempfangenden oder strahlungsemittierenden Halbleiterchip (1), der an oder auf einem Sockelteil (4) befestigt und mit wenigstens zwei für die elektrische Kontaktgabe des Bauelementes dienenden Elektrodenanschlüssen (2, 3) aus einem elektrisch leitenden Anschluss-Material verbunden ist,
wobei
- das Sockelteil (4) mit einer dünnen Beschichtung (16, 16a) aus dem elektrisch leitenden Anschluss-Material durch chemische Abscheidung aus einer Flüssigkeit ohne Einwirkung eines äußeren elektrischen Stromflusses überzogen wird,
- auf der dünnen Sockelteil-Beschichtung eine Maskenschicht (21) abgeschieden wird, und
- die Maskenschicht (21) strukturiert wird, wodurch von dem Maskenmaterial abgedeckte und nicht abgedeckte Bereiche der Sockelteil-Beschichtung ausgewiesen werden,
- selektiv die nicht durch das Material der Maskenschicht abgedeckten Bereiche durch Ätzen entfernt werden, und
- die Strukturierung der Maskenschicht (21) unter der Einwirkung eines Teilchen- oder Lichtstrahls erfolgt.

2. Verfahren nach Anspruch 1,
**dadurch gekennzeichnet,**
**dass** das Material der Maskenschicht (21) Zinn aufweist.

3. Verfahren nach Anspruch 1 oder 2,
**dadurch gekennzeichnet,**
**dass** die Strukturierung der Maskenschicht (21) unter der Einwirkung eines Laserstrahls erfolgt.

4. Verfahren nach einem der Ansprüche 1 bis 3,
**dadurch gekennzeichnet,**
**dass** das selektive Entfernen der nicht abgedeckten Bereiche der Sockelteil-Beschichtung durch chemisches Nassätzen erfolgt.

5. Verfahren nach einem der Ansprüche 1 bis 4,
**dadurch gekennzeichnet,**
**dass** die Beschichtung (16) des Sockelteils (4) mit dem elektrisch leitenden Anschluss-Material allseitig erfolgt.

6. Verfahren nach einem der Ansprüche 1 bis 5,
**dadurch gekennzeichnet,**
**dass** das Anschluss-Material der Sockel-Beschichtung Kupfer aufweist.

7. Verfahren nach einem der Ansprüche 1 bis 6,
**dadurch gekennzeichnet,**
**dass** das Sockelteil (4) aus Kunststoff besteht und im Spritzgussverfahren vorgefertigt wird.

## Claims

1. Method for producing an optoelectronic device with a radiation-receiving or radiation-emitting semiconductor chip (1) which is mounted to or on a base part (4) and is connected with at least two electrode terminals (2, 3) of an electrically conductive terminal material serving in electrical contacting of the device,
wherein
- the base part (4) is coated with a thin coating (16, 16a) of the electrically conductive terminal material by chemical deposition from a liquid without the action of an external electric current flow,
- a mask layer (21) is deposited on the thin base part coating, and
- the mask layer (21) is patterned, whereby regions of the base part coating covered and not covered by the mask material are identified,
- the regions not covered by the material of the mask layer are selectively removed by etching, and
- patterning of the mask layer (21) proceeds under the action of a particle or light beam.

2. Method according to claim 1,
**characterized in that**
the material of the mask layer (21) comprises tin.

3. Method according to claim 1 or 2,
**characterized in that**
patterning of the mask layer (21) proceeds under the action of a laser beam.

4. Method according to one of claims 1 to 3,
**characterized in that**
selective removal of the non-covered regions of the base part coating proceeds by wet chemical etching.

5. Method according to one of claims 1 to 4,
**characterized in that**
coating (16) of the base part (4) with the electrically conductive terminal material proceeds on all sides.

6. Method according to one of claims 1 to 5,
**characterized in that**
the terminal material of the base coating comprises copper.

7. Method according to one of claims 1 to 6,
**characterized in that**
the base part (4) consists of plastics and is prefabricated using the injection molding process.

## Revendications

1. Procédé de fabrication d'un composant optoélectronique muni d'une puce à semi-conducteur (1) réceptrice de rayonnement ou émettrice de rayonnement, laquelle est fixée contre ou sur une partie de socle (4) et est reliée à au moins deux bornes d'électrode (2, 3) servant à la mise en contact électrique du composant, constituées d'une matière de connexion électroconductrice,
- la partie de socle (4) étant enrobée par un revêtement (16, 16a) mince constitué de la matière de connexion électroconductrice par déposition chimique à partir d'un liquide, sans action d'un flux de courant électrique extérieur,
- une couche de masquage (21) étant déposée sur le revêtement mince de la partie de socle, et
- la couche de masquage (21) étant structurée, sur quoi des zones recouvertes par la matière de masquage et des zones non recouvertes par la matière de masquage du revêtement de la partie de socle apparaissent,
- les zones non recouvertes par la matière de la couche de masquage étant sélectivement enlevées par gravure, et
- la structure de la couche de masquage (21) étant réalisée sous l'action d'un rayon de particules ou d'un rayon lumineux.

2. Procédé selon la revendication 1,
**caractérisé en ce**
**que** la matière de la couche de masquage (21) présente de l'étain.

3. Procédé selon la revendication 1 ou 2,
**caractérisé en ce**
**que** la structure de la couche de masquage (21) est réalisée sous l'action d'un rayon laser.

4. Procédé selon l'une quelconque des revendications 1 à 3,
**caractérisé en ce**
**que** l'enlèvement sélectif des zones non recouvertes du revêtement de la partie de socle est réalisé par gravure humide chimique.

5. Procédé selon l'une quelconque des revendications 1 à 4,
**caractérisé en ce**
**que** le revêtement (16) de la partie de socle (4) à l'aide de la matière de connexion électroconductrice est réalisé sur tous les côtés.

6. Procédé selon l'une quelconque des revendications 1 à 5,
**caractérisé en ce**
**que** la matière de connexion du revêtement de socle présente du cuivre.

7. Procédé selon l'une quelconque des revendications 1 à 6,
**caractérisé en ce**
**que** la partie de socle (4) est constituée de matière plastique et est préfabriquée selon le procédé de moulage par injection.
